# NEW EUROPEAN PATENT SPECIFICATION

(11) **EP 0 882 072 B2**
(45) Date of publication and mention of the opposition decision: **26.10.2005**
(45) Mention of the grant of the patent: 08.11.2000
(21) Application number: 97902731.5
(22) Date of filing: 07.02.1997
(51) Int. Cl.: C08F 2/50, G03F 7/004, C09D 4/00

(54) **ANIONIC PHOTOCATALYST**
ANIONISCHE PHOTOKATALYSATOR
PHOTOCATALYSEUR ANIONIQUE

(30) Priority: 22.02.1996 EP 96200466
(43) Date of publication of application: 09.12.1998
(73) Proprietor: Ciba Specialty Chemicals Holding Inc., 4057 Basel (CH)
(72) Inventor: STANSSENS, Dirk, Armand, Wim, B-3530 Houthalen (BE); JANSEN, Johan, Franz, Gradus, Antonius, NL-6165 AP Geleen (NL)
(86) International application number: PCT/NL1997/000042
(87) International publication number: WO 1997/031033

(56) References cited:
- WO-A-94/28075
- WO-A-95/14716
- DE-A- 2 020 937
- US-A- 5 017 649
- J. Cameron et al., Journal of American Chemical Society, No. 113, pp. 4303-4313, 1991
- V. Pillai, Synthesis, 1980, Thieme Publ. Reviews pp. 1-26
- E. Urakar et al., Polymer preprints, vol. 35, No. 2, August 1994, p. 933
- R. Clemens et al., Journal of Coatings Technology, Vol. 61, No. 770, March 1989, pp. 83-91
- J. Barltrop et al., Tetrahedron Letters No. 6, pp. 697-699, 1962
- CRC Handbook of Chemistry and Physics, 65th Ed., 1984-85. p. D-163

## Description

### FIELD OF THE INVENTION

The invention relates to an anionic photocatalyst and to a composition comprising a polymerizable material and the anionic photocatalyst.

### BACKGROUND OF THE INVENTION

A photocatalyst is a species that efficiently absorbs ultraviolet light and generates, through a series of photochemical energy transformations, an initiator or a catalyst which are capable of initiating or catalyzing polymerization. A photocatalyst which upon absorption of ultraviolet light transfers into an electronically excited state and is directly involved in the production of initiator radicals is known as a photoinitiator.

Photoinitiators are well known for use in initiation of polymerization and crosslinking processes. Upon subjection to light or irradiation all suitable wave length, the photoinitiator produces a reactive species which can initiate the polymerisation or crosslinking process. Most common are radical photoinitiator, where the reactive species is a radical. Polymerization can also proceed using a photocatalyst which produces after irradiation an acid (cationic photocatalyst) or a base (anionic photocatalyst) as reactive species. Of these photocatalysts, the anionic photocatalysts are relatively rare.

A composition comprising a binder and an anionic photoactive compound is known from E.J. Urankar and J. M.J Frechet, Polymer Preprints Vol. 35 (II), 933-34 (1994). Said article describes the crosslinking of a copolymer film by free amine liberated from a photocatalyst. The catalyst disclosed in said article has as a disadvantage not to be active in the catalysis of some polymerisation- and crosslinking reactions such as, for example, several Michael type additions and epoxide additions.

### SUMMARY AND OBJECTS OF THE INVENTION

It is an object of the present invention to provide a more effective anionic photocatalyst. It is another object of the invention to provide a composition comprising an anionic photocatalyst having good stability and good solubility in polymerizable material.

A composition according to the present invention comprises:
a) polymerizable material and
b) an anionic photocatalyst characterized in that the anionic photocatalyst has the structural formula:

   Z-A,

   wherein Z is a photolabile group, A is a strong base and 2 is covalently bound to A and wherein the anionic photocatalyst is a photolabile compound able to liberate a strong base with a pKₐ ≥ 12.

The structural formula of the photocatalyst can be illustrated as follows:

Z-A

wherein Z is a photolabile group, A is a strong base and Z is covalently bound to A. The strong base is preferably a nitrogen containing compound. Preferred nitrogen containing compounds include amines, for example, secundary amines, guanidines and amidines.

The invention further relates to specific nitrogen containing compounds for use as photocatalysts.

### PRIOR ART

T. Nishikubo , E. Takehara and A. Kameyama (Polymer J, no. 4, 25 (1993), 421-425) describe the thermal curing of epoxy resin and the polyurethane oligomer with bis (4-formylaminophenyl)methane as a photocatalyst. The base generated is an aromatic amine, which amine is a weak base and functions as a crosslinking agent.

Cameron and Fréchet (J. Photochem. Photobiol. A: Chem. 59, (1991) 105-113) disclose anionic photocatalysts being amines having a α,α-dimethyl-3,5-dimethoxybenzyloxycarbonyl moiety. The base according to the example of this reference is cyclohexylamine, which is not very effective.

WO-95/31486 discloses anionic photocatalysts consisting of platinum, iron or ruthenium complexes.

DE-A-2020937 describes N-acylguanidines having the general formula: 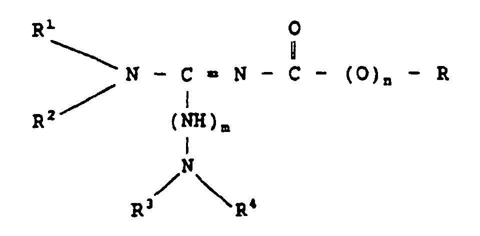 wherein R, R¹, R², R³ and R⁴ are substituted or unsubstituted aliphatic, aromatic or heterocyclic groups. This general formula can overlap with the general formula of the photocatalyst according to the present invention, in case that n=1, m=0, R¹, R², R³ and R⁴ are CH₃- and R is phenyl-CH₂. DE-A-2020937 discloses the use of these N-acylguanidines as a plant protection agent. There is nowhere given a disclosure or a suggestion for the use of said guanidine as a photocatalyst or for the use in a photocurable composition.

WO 94/28075 discloses a coating composition including an UV-deblockable basic catalyst. The coating composition is based upon an activated unsaturated group-containing compound, an activated CH-group-containing compound and a basic catalyst, wherein the basic catalyst is blocked with an acidic compound whereby the so-blocked catalyst becomes unblocked under the influence of UV-light. In WO 94/28075 the blocking agents are acidic compounds selected from α-keto carboxylic acids, aromatic or N-heterocyclic substituted formic, acetic and oxyacetic acids, and halide compounds.The use of these compounds gives rise to salt-formation.

### DETAILED DESCRIPTION OF THE INVENTION

The anionic photocatalyst according to the present invention is able to liberate a strong base having a pKₐ about ≥ 12, and the anionic photocatalyst has the following structure:

Z-A

wherein Z is a photolabile group, A is a strong base and Z is covalently bound to A.

The strong base is preferably a nitrogen containing compound.

The photolabile group Z can be any group that decomposes under the influence of irradiation (such as for example, ultraviolet light, electron beam, infrared or laser irradiation) in such a way that a strong base is liberated from the compound with the formula Z-A.

Examples of suitable labile groups include fluorenones, xanthones, thioxanthones, biphenyles and arytalkoxycarbonyles such as for example m-nitrophenyl oxycarbonyl, 3,5-dimethoxybenzyloxycarbonyl, and o-nitrobenzyloxycarbonyl, 3,4-dimethoxy-o-nitrobenzyloxycarbonyl and phenyl-(o-nitrophenyl)methyloxycarbonyl.

A preferred labile group Z is an arylalkoxycarbonylgroup having the formula: 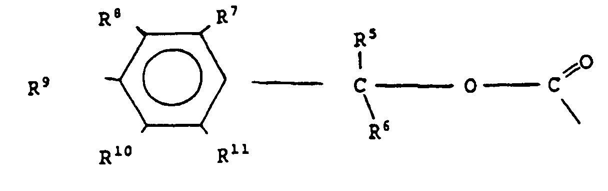 in which R⁵, R⁶, R⁷, R⁸, R⁹, R¹⁰ and R¹¹ can be independently a group selected from hydrogen, (C₁-C₂₀) alkyl, aryl, aryl-alkyl, halogen, alkyl-O-, aryl-O-, aryl-alkyl-O-, alkyl-S-, aryl-S-, aryl-alkyl-S-, alkyl-N-, aryl-N-, acryl-alkyl-N, NO₂-, cyano, carboxylic esters, carboxylic amides, ketones or aldehydes in which R⁵, R⁶, R⁷, R⁸, R⁹, R¹⁰ and R¹¹ can also form one or more ringstructures.

Preferably R⁵, R⁶, R⁷, R⁸, R⁹, R¹⁰ and R¹¹ are hydrogen atoms.

In one preferred embodiment of the invention R⁸ and R¹⁰ are methoxy groups and R⁵ and R⁶ are methyl groups.

In another preferred embodiment R⁷ and/or R¹¹ are -NO₂.

In a further preferred embodiment R⁸ and R¹⁰ are -OCH₃, R⁵ is H and R⁶ is

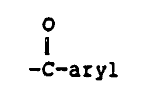

In yet another preferred embodiment R⁹ is an arylgroup and R⁵ and R⁶ are methylgroups.

In the formula Z-A, A can be, for example, a secundary amine, a guanidine or an amidine group. The guanidine groups are for example described in EP-A-490422.

Preferably A has the following formula:

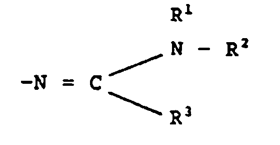

According to a further preferred embodiment A is represented by the formula:

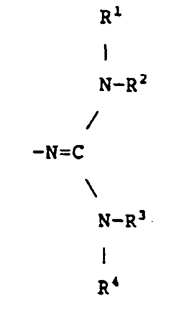

In these formulas R¹, R², R³ and R⁴ can be independently a group selected from hydrogen, (C₁-C₂₀) alkyl, aryl, aryl-alkyl, halogen, alkyl-O-, aryl-O-, aryl-alkyl-O-, aryl-N-, alkyl-N, aryl-alkyl-N, alkyl-S-, aryl-S-, aryl-alkyl-S-, NO₂-, cyano, carboxylic ester carboxylic amide, ketones or aldehydes, whereas R¹, R², R³ and/or R⁴ can also form ringstructures and wherein R⁵, R⁶, R⁷, R⁸, R⁹, R¹⁰ and R¹¹ can also form independently from R¹, R², R³ and R⁴ one or more ringstructures.

A preferred anionic photocatalyst (Z-A) has the following formula:

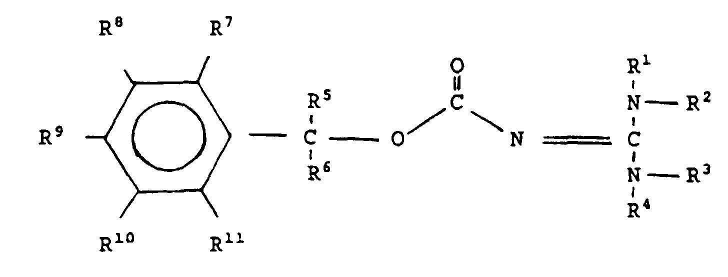

Preferably, R¹, R², R³ and R⁴ are methyl groups and R⁵ to R¹¹ are hydrogen atoms.

In another preferred embodiment R¹, R², R³, R⁴, R⁵ and R⁶ are methyl groups, R⁸ and R¹⁰ are methoxy groups and R⁷, R⁹ and R¹¹ are hydrogen atoms.

According to a further preferred embodiment R¹, R², R³ and R⁴ are methyl groups, R⁷ is a nitro group and R⁵, R⁶, R⁸, R⁹, R¹⁰ and R¹¹ are hydrogen atoms.

In another preferred embodiment of the present invention R¹, R², R³ and R⁴ are methyl groups, R⁷ and R¹¹ are nitro groups and R⁵, R⁶, R⁸, R⁹ and R¹⁰ are hydrogen atoms.

It is also advantageous to select R¹, R², R³ and R⁴ methyl, R⁵, R⁷, R⁹ and R¹¹ hydrogen, R⁶ 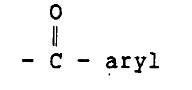 and R⁸ and R¹⁰ methoxy groups or
R¹, R², R³, R⁴, R⁵ and R⁶ methyl groups, R⁹ aryl and R⁷, R⁸, R¹⁰ and R¹¹ hydrogen.

The polymerizable material according to the present invention is an anionic curable composition comprising one or more polymerizable components such as monomers, oligomers or polymers.

Suitable polymerisable components include, for example, aldehydes, ketones, ethylenically unsaturated monomers including ethylene, 1,3-dienes, styrene and α-methyl styrene, acrylates and methacrylates, itaconates, (meth) acrylonitrile, (meth)acrylamide, N-carboxy-α-amino anhydrides, cyclic amides, cyclic esters epoxides and siloxanes. Furthermore components having for example an amine, thiol, epoxide, carboxyl, isocyanate, (meth)acrylate, unsaturated carbonyl, cyclic carbonate, acetoacetate, malonate or alcohol functionality can be applied.

Other suitable polymers include for example polyacrylates, polyolefines, (un)saturated polyesters, polyamides, polyethers and hydrocarbon polymers having above mentioned functionalities as end group, in a side chain or in the backbone.

The polymerizable material can be a combination of suitable components such as for example acetoacetate-(meth)acrylate, thiol-epoxide, thiol-unsaturated carbonyl, thiol-isocyanate, carboxylic acid-epoxide, amino-cyclic carbonate, thiol-cyclic carbonate, hydroxy-isocyanate, malonate-acrylate, ketone-acrylate and amine-unsaturated carboxyl mixtures.

The concentration of the anionic photocatalyst can range between, for example, 0,01 and 10% by weight (relative to the polymerisable material). The irradiation conditions and the amount of photocatalyst and other additives is dependent upon formulation and application end-use requirements.

Other suitable additives include for example pigments and sensitizers. Suitable sensitizers are for example summarized in WO 95/14716.

The products according to the present invention can be used in coatings and inks serving for example the printing and packaging industry and also in other markets including for example wood, adhesives, photo-imaging, fibre optics, printing plates and 3D photomodelling. The use in the coating industry can be in powder paint formulations for powder coatings but also in water based coatings, solvent based coatings and 100% solid system in wet-coatings.

The photocatalyst according to the invention can also be used in photoimaging and photoresist material, where the photocatalyst can cause direct crosslinking or can also be used to neutralise the acid in acid cure systems, such that areas which are not exposed to light can cure.

The compound according to the present invention can also be applied as a strong base generating species, as a neutralising agent, and also as an alkaline making agent, because the pH shift in a coating caused by the liberation of the strong base can be used for color changes in colored systems in which pH sensitive dyes are incorporated.

The invention will further be described based on the following non-limiting examples.

### Experiment I

### Preparation of benzyloxycarbonyl tetramethylquanidine (Z-TMG)

To a stirred solution of 88g benzyloxycarbonyl hydroxysuccinimid in 300 ml dichloromethane was slowly added 41 g tetramethyl guanidine in 100 ml dichloromethane. The reaction mixture was stirred overnight and subsequently washed with water (3 times 100 ml) and a saturated sodium carbonate solution (3 times 100 ml). These washings were followed by a very quick washing with 100 ml of 0.1 n hydrochloric acid solution followed by washing with a saturated sodium carbonate solution and water. Drying over sodium sulphate was followed by evaporation of the solvent under reduced pressure. 70 g (80%) Z-TMG was obtained. ¹H-NMR: 200MHz, CDCl₃ δ: 7.5-7.2 (m,5H) 5.15 (s, 2H) 2.9 (s, 12H).

### Example I

### Curing of an unsaturated polyester and pentaerythritoltetrakis(3-mercaptopropionate) mixture with Z-TMG

5g unsaturated polyester (ZA1832 DSM Resins, WPU=750), 0.9g pentaerythritol-tetrakis(3-mercaptopropionate) and 0.3 g Z-TMG according to Experiment I were dissolved in 5 ml tetrahydrofurane (THF). A 150pm coating was drawn on an alumina Q-panel and the THF was evaporated from the coating overnight. The coating was irradiated during 10 sec with a mercury lamp (dose 3 J/cm²). After irradiation a coating was formed (as was proved with the aceton resistance test which test resulted in ADR>100).

In said test more than 100 acetone double rubs (>100 ADR) indicates full curing, whereas 25-100 acetone double rubs indicates a partial curing. Without irradiation the ADR was 4, which means that there was no curing.

### Comparative Experiment A

### Attempted cure with α-nitro-benzyloxycarbonyl cyclohexylamine

Example I was repeated with the exception that instead of Z-TMG, α-nitro-benzyloxycarbonyl cyclohexylamine was applied.

Result: No curing was observed after irradiation. (ADR = 4)

### Comparative Experiment B

### Attempted cure with benzyloxycarbonyl benztriazole

Example I was repeated with the exception that instead of Z-TMG benzyloxycarbonyl benztriazole was applied.

Result: No curing was observed after irradiation. (ADR = 4)

### Example II

### Curing of a carboxylic acid epoxide mixture with Z-TMG

11.7 g (Uralac P3500™; acid value = 35, DSM Resins), 0.62 g trisglycidylisocyanurate (TGIC) and 0.2g Z-TMG were dissolved in 10 ml THF. A coating was drawn according to Example I and the coating was irradiated during 10 sec (dose 3 J/cm²). After the irradiation the coating underwent a post-cure treatment for 10 min at 150°C.

Result: A crosslinked coating was obtained (ADR >100).

### Comparative Experiment C

### Z-TMG without irradiation

Analogous to Example II, a coating was prepared, however the coating was not irradiated.

Result: Hardly any crosslinking was observed. (ADR = 20)

### Comparative Experiment D

### Blank without catalyst

Coatings were prepared analogous to Example II, however no Z-TMG catalyst was used.

Result: No crosslinking was observed. (ADR=10)

### Comparative Experiment E

### Curing with TMG

Coatings were prepared analogous to Example II, with the exception that TMG instead of Z-TMG was used as catalyst.

Result: Crosslinking was observed (ADR > 100) without irradiation, however the coating composition was not stable because the catalyst was not blocked.

### Example III

### Curing of an acrylate acetoacetate mixture with Z-TMG

Analogous to Example I a coating was prepared from the following mixture: 6.6g of an acrylate functional polyacrylate having a WPU = 660, 1.3 g of pentaerythritol trisacetoacetate and 0.065g Z-TMG.

After irradiation a cured coating having an aceton resistance ADR > 100 and having a König pendulum hardness of 158 sec. was obtained.

### Example IV

Example III was repeated, however, before irradiation 8g of the pigment TiO₂ was homogeneously dispersed in the mixture. Immediately after irradiation for 40 sec (12 J/cm²) the surface seemed cured (visual) but no through cure could be detected (ADR = 7).

The coating was followed for depth of cure (cure without irradiation) during a week.

Result: 1 hour: ADR 18; 1 day ADR 30; 2 days: ADR 52, 1 week ADR >100, indicating that the liberated catalyst remains active.

This constitutes a major advantage of anionic curing mechanism over a radical curing mechanism, as radicals have a very short life-time.

### Example V

Example III was repeated with as the acrylate an epoxyacrylate (Sartomer CN120™) and 0.4% by weight Z-TMG as catalyst whereas THF was omitted as solvent.

A coating having a thickness of 75pm drawn from this liquid on a glass plate and cured with 3 J/cm² (using a Fusion D-bulb as source of UV light).

Result: After irradiation a cured coating was obtained.

### Example VI

Example III was repeated with urethane acrylate (Sartomer CN 963-A80™) as the acrylate and the amount of Z-TMG was raised to 3% by weight. A coating having a thickness of 75pm drawn from this liquid on a glass plate and cured with 1 J/cm² (using a Fusion D-bulb as source of UV light).

Result: After irradiation a cured coating was obtained.

### Example VII

Example III was repeated with polyester acrylate (Ebecryl 810™) as the acrylate.

A coating having a thickness of 75pm drawn from this liquid on a glass plate and cured with 3 J/cm² (using a Fusion D-bulb as source of UV light).

Result: After irradiation a cured coating was obtained.

### Example VIII

Example VII was repeated with the exception that also 6% by weight benzophenone was added as a sensitizer.

Result: only a dose of 0,5 J/cm² was needed to obtain a cured coating.

These examples show that irradiation of a composition comprising a photocatalyst according to the invention results in cured coatings.

## Claims

1. Composition comprising:
a) polymerizable material and
b) an anionic photocatalyst, **characterized in that** the anionic photocatalyst has the structural formula:
Z-A
wherein Z is a photolabile group, A is a strong base and Z is covalently bound to A and wherein the anionic photocatalyst is a photolabile compound able to liberate a strong base having a pKₐ ≥ 12.

2. Composition according to Claim 1, **characterized in that** the strong base is a nitrogen containing compound.

3. Composition according to Claim 2, **characterized in that** the nitrogen containing compound is an amine.

4. Composition according to claim 3, **characterized in that** the amine is a secondary amine, a guanidine or an amidine.

5. Composition according to any one of Claims 1-4 **characterized in that** the anionic photocatalyst has the structural formula: 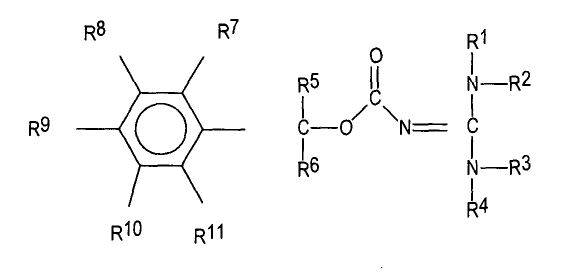 wherein R¹, R², R³, R⁴, R⁵, R⁶, R⁷, R⁸, R⁹, R¹⁰ and R¹¹ can be independently a group selected from hydrogen, (C₁-C₂₀) alkyl, aryl, aryl-alkyl, halogen, alkyl-O-, aryl-O-, aryl-alkyl-O-, aryl-N-, alkyl-N-, aryl-alkyl-N, alkyl-S-, aryl-S-, aryl-alkyl-S-, NO₂-, cyano, carboxylic ester, carboxylic amide, ketones or aldehydes and wherein R¹, R², R³ and/or R⁴ can also form a ringstructure and wherein R⁵, R⁶, R⁷, R⁸, R⁹, R¹⁰ and R¹¹ can also form independently from R¹, R², R³ and R⁴ one or more ringstructures.

6. Composition according to any one of claims 1-5, **characterized in that** the composition comprises 0.01-10% by weight of the anionic photocatalyst.

7. Catalyst having the structural formula: 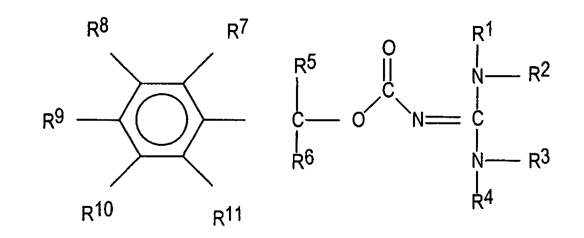 **characterized in that** R¹, R², R³ and R⁴ are methyl groups and R⁵ to R¹¹ are hydrogen atoms or **in that** R¹, R², R³, R⁴, R⁵ and R⁶ are methyl groups, R⁸ and R¹⁰ are methoxy groups and R⁷, R⁹ and R¹¹ are hydrogen atoms or **in that** R¹, R², R³ and R⁴ are methyl groups, R⁷ is a nitro group and R⁵, R⁶, R⁸, R⁹, R¹⁰ and R¹¹ are hydrogen atoms or **in that** R¹, R², R³ and R⁴ are methyl groups R⁷ and R¹¹ are nitro groups and R⁵, R⁶, R⁸, R⁹ and R¹⁰ are hydrogen atoms or **in that** R¹, R², R³ and R⁴ are methyl, R⁵, R⁷, R⁹ and R¹¹ are hydrogen, R⁶ is 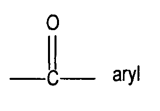 and R⁸ and R¹⁰ are methoxy groups or **in that**
R¹, R², R³, R⁴, R⁵ and R⁶ are methyl groups, R⁹ is aryl and R⁷, R⁸, R¹⁰ and R¹¹ are hydrogen excluding a compound having the formula: 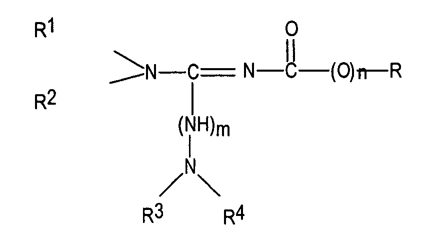 wherein n=1, m=0, R¹, R², R³ and R⁴ are -CH₃ and R is phenyl-CH₂.

8. Composition according to any one of claims 1-6, **characterized in that** the anionic photocatalyst is a compound according to claim 7.

9. Use of photolabile compound as defined in any one of claims 1-5 as a photocatalyst.

10. Radiation curable coating composition comprising a composition according to any one of claims 1-6 or 8.

## Patentansprüche

1. Zusammensetzung umfassend:
a) ein polymerisierbares Material und
b) einen anionischen Photokatalysator, **dadurch gekennzeichnet, dass** der anionische Photokatalysator die Strukturformel:
Z-A
aufweist, wobei Z eine photolabile Gruppe ist, A eine starke Base ist und Z kovalent an A gebunden ist und wobei der anionische Photokatalysator eine photolabile Verbindung ist, welche imstande ist, eine starke Base mit einem pKₐ ≥ 12 freizusetzen.

2. Zusammensetzung nach Anspruch 1, **dadurch gekennzeichnet, dass** die starke Base eine Stickstoff-enthaltende Verbindung ist.

3. Zusammensetzung nach Anspruch 2, **dadurch gekennzeichnet, dass** die Stickstoff-enthaltende Verbindung ein Amin ist.

4. Zusammensetzung nach Anspruch 3, **dadurch gekennzeichnet, dass** das Amin ein sekundäres Amin, ein Guanidin oder ein Amidin ist.

5. Zusammensetzung nach einem der Ansprüche 1 - 4, **dadurch gekennzeichnet, dass** der anionische Photokatalysator die Strukturformel: 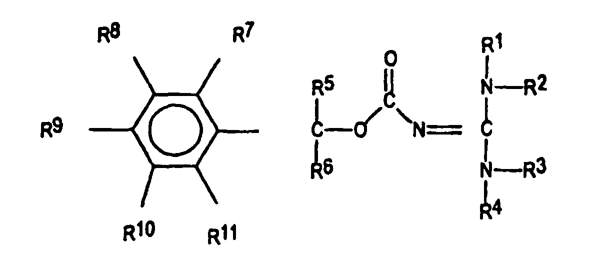 aufweist, wobei R¹, R², R³, R⁴, R⁵, R⁶, R⁷, R⁸, R⁹, R¹⁰ und R¹¹ unabhängig eine Gruppe, ausgewählt aus Wasserstoff, (C₁ - C₂₀)-Alkyl, Aryl, Aryl-Alkyl, Halogen, Alkyl-O-, Aryl-O-, Aryl-Alkyl-O-, Aryl-N-, Alkyl-N-, Aryl-Alkyl-N, Alkyl-S-, Aryl-S-, Aryl-Alkyl-S-, NO₂-, Cyano, Carbonsäureester, Carbonsäureamid, Ketonen oder Aldehyden, sein können und wobei R¹, R², R³ und/oder R⁴ ebenfalls eine Ringstruktur bilden können und
wobei R⁵, R⁶, R⁷, R⁸, R⁹, R¹⁰ und R¹¹ ebenfalls unabhängig von R¹, R², R³ und R⁴ eine oder mehrere Ringstruktur(en) bilden können.

6. Zusammensetzung nach einem der Ansprüche 1 - 5, **dadurch gekennzeichnet, dass** die Zusammensetzung 0,01 - 10 Gew.-% des anionischen Photokatalysators umfasst.

7. Katalysator mit der Strukturformel: 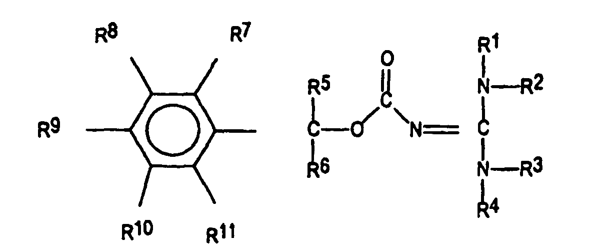 **dadurch gekennzeichnet, dass** R¹, R², R³ und R⁴ Methylgruppen sind und R⁵ bis R¹¹ Wasserstoffatome sind oder dass R¹, R², R³, R⁴, R⁵ und R⁶ Methylgruppen sind, R⁸ und R¹⁰ Methoxygruppen sind und R⁷, R⁹ und R¹¹ Wasserstoffatome sind oder dass R¹, R², R³ und R⁴ Methylgruppen sind, R⁷ eine Nitrogruppe ist und R⁵, R⁶, R⁸, R⁹, R¹⁰ und R¹¹ Wasserstoffatome sind oder dass R¹, R², R³ und R⁴ Methylgruppen sind, R⁷ und R¹¹ Nitrogruppen sind und R⁵, R⁶, R⁸, R⁹ und R¹⁰ Wasserstoffatome sind oder dass R¹, R², R³ und R⁴ Methylgruppen sind, R⁵, R⁷, R⁹ und R¹¹ Wasserstoff sind, R⁶ 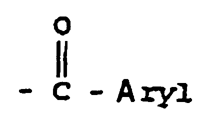 ist, und R⁸ und R¹⁰ Methoxygruppen sind oder dass R¹, R², R³, R⁴, R⁵ und R⁶ Methylgruppen sind, R⁹ Aryl ist und R⁷, R⁸, R¹⁰ und R¹¹ Wasserstoff sind, wobei eine Verbindung mit der Formel: 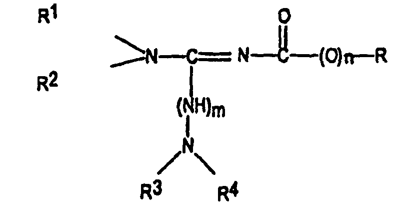 ausgeschlossen ist, worin n=1, m=0, R¹, R², R³ und R⁴ -CH₃ sind und R Phenyl-CH₂ ist.

8. Zusammensetzung nach einem der Ansprüche 1 - 6 , **dadurch gekennzeichnet, dass** der anionische Photokatalysator eine Verbindung nach Anspruch 7 ist.

9. Verwendung einer der in einem der Ansprüche 1 - 5 beschriebenen photolabilen Verbindungen als Photokatalysator.

10. Strahlungshärtbare Beschichtungszusammensetzung, umfassend eine Zusammensetzung nach einem der Ansprüche 1 - 6 oder 8.

## Revendications

1. Composition comprenant :
a) un matériau polymérisable, et
b) un photocatalyseur anionique, **caractérisé en ce que** le photocatalyseur anionique possède la formule structurelle :
Z-A
dans laquelle Z représente un groupe photolabile, A est une base forte et Z est lié à A par une liaison covalente et où le photocatalyseur anionique est un composé photolabile capable de libérer une base forte avec un pKₐ ≥ 12.

2. Composition selon la revendication 1, **caractérisée en ce que** la base forte est un composé azoté.

3. Composition selon la revendication 1, **caractérisée en ce que** le composé azoté est une amine.

4. Composition selon la revendication 3, **caractérisée en ce que** l'amine est une amine secondaire, une guanidine ou une amidine.

5. Composition selon l'une quelconque des revendications 1 à 4, **caractérisée en ce que** le photocatalyseur anionique possède la formule structurelle : 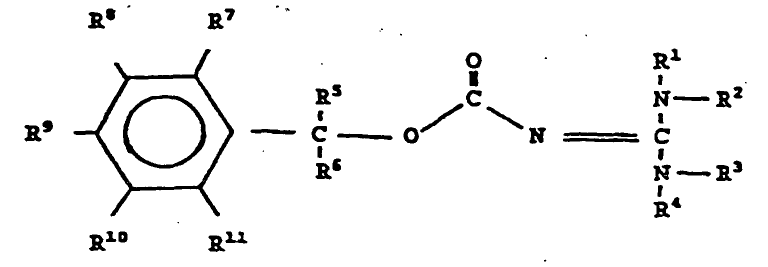 dans laquelle R¹, R², R³, R⁴, R⁵, R⁶, R⁷, R⁸, R⁹, R¹⁰ et R¹¹ peuvent être indépendamment un groupe choisi parmi un atome d'hydrogène ou un groupe alkyle en C₁-C₂₀, aryle, aryl-alkyle, halogène, alkyl-O-, aryl-O-, aryl-alkyl-O-, alkyl-N-, aryl-N-, acyl-alkyl-N-, alkyl-S-, aryl-S-, aryl-alkyl-S-, NO₂-, cyano, ester carboxylique, amide carboxylique, cétones ou aldéhydes et dans laquelle R¹, R², R³ et/ou R⁴ peuvent aussi former une ou plusieurs structures cycliques et dans laquelle R⁵, R⁶, R⁷, R⁸, R⁹, R¹⁰ et R¹¹ peuvent également former indépendamment de R¹, R², R³ et R⁴ une ou plusieurs structures cycliques.

6. Composition selon l'une quelconque des revendications 1 à 5, **caractérisée en ce que** la composition comprend de 0,01 à 10 % en masse du photocatalyseur anionique.

7. Catalyseur possédant la formule structurelle : 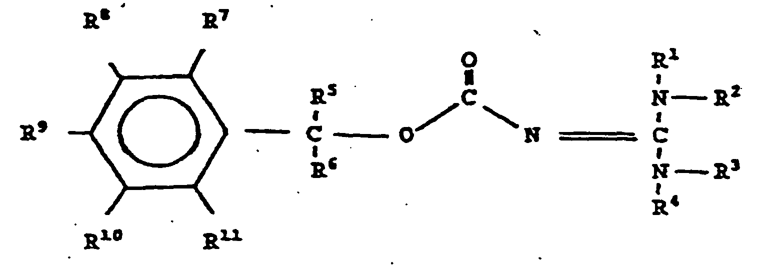 **caractérisé en ce que** R¹, R², R³ et R⁴ représentent des groupes méthyle et R⁵ à R¹¹ représentent des atomes d'hydrogène ou **en ce que** R¹, R², R³, R⁴, R⁵ et R⁶ représentent des groupes méthyle, R⁸ et R¹⁰ représentent des groupes méthoxy et R⁷, R⁹ et R¹¹ représentent des atomes d'hydrogène ou **en ce que** R¹, R², R³ et R⁴ représentent des groupes méthyle, R⁷ représente un groupe nitro et R⁵, R⁶, R⁸, R⁹, R¹⁰ et R¹¹ représentent des atomes d'hydrogène ou **en ce que** R¹, R², R³ et R⁴ représentent des groupes méthyle et R⁷ et R¹¹ représentent des groupes nitro et R⁵, R⁶, R⁸, R⁹ et R¹⁰ représentent des atomes d'hydrogène ou **en ce que** R¹, R², R³ et R⁴ représentent des groupes méthyle, R⁵, R⁷, R⁹ et R¹¹ représentent des atomes d'hydrogène, R⁶ représente 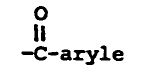 et R⁸ et R¹⁰ représente groupes méthoxy, ou **en ce que** R¹, R², R³, R⁴, R⁵ et R⁶ représente des groupes méthyle, R⁹ représente un groupe aryle et R⁷, R⁸, R¹⁰ et R¹¹ représentent des atomes d'hydrogène à l'exception d'un composé possédant la formule : 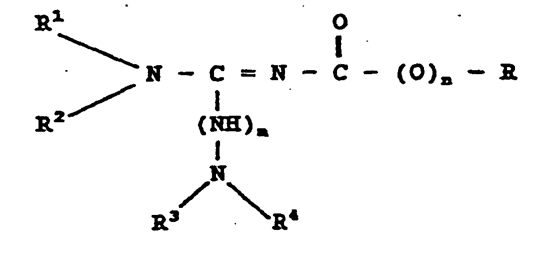 où n=1, m=0, R¹, R², R³ et R⁴ sont -CH₃ et R est phényl-CH₂.

8. Composition selon l'une quelconque des revendications 1 à 6, **caractérisé en ce que** le photocatalyseur anionique est un composé selon la revendication 7.

9. Utilisation d'un composé photolabile tel que défini dans l'une quelconque des revendications 1 à 5 en tant que photocatalyseur.

10. Composition de revêtement durcissable par irradiation comprenant une composition selon l'une quelconque des revendications 1 à 6 ou 8.
